# EUROPEAN PATENT APPLICATION

(11) **EP 4 554 047 A1**
(43) Date of publication of application: **14.05.2025**
(21) Application number: 24769220.5
(22) Date of filing: 12.09.2024
(51) Int. Cl.: H02J 50/12, H02J 50/80, H02J 50/20, H03K 17/284, H02M 3/00, H02J 50/90, H01F 38/14

(54) **ELECTRONIC DEVICE AND METHOD FOR WIRELESS CHARGING SUPPORTING MULTIPLE FREQUENCIES, AND NON-TRANSITORY STORAGE MEDIUM**

(30) Priority: 22.09.2023 KR 20230127116; 02.01.2024 KR 20240000393
(71) Applicant: Samsung Electronics Co., Ltd, Suwon-si, Gyeonggi-do 16677 (KR)
(72) Inventor: MIN, Geonhong, Suwon-si, Gyeonggi-do 16677 (KR)
(74) Representative: HGF
(86) International application number: PCT/KR2024/013911
(87) International publication number: WO 2025/063629

(57) **Abstract**

The disclosure is related to an electronic device, method, and a non-transitory storage medium for wireless charging supporting multiple frequencies, according to an embodiment, the electronic device may include resonance circuit including a coil configured to wirelessly receive power from an external electronic wireless charging transmitter and a first capacitor, a rectifier circuit connected to the resonance circuit, a communication circuit, and a control circuit electrically connected to the rectifier circuit, the resonance circuit, and the communication circuit. According to an embodiment, the rectifier circuit may include a plurality of switches, and a plurality of switch driver circuits each electrically connected to one of the plurality of switches, and at least two switch driver circuits of the plurality of switch driver circuits include at least one delay. According to an embodiment, the control circuit may be configured to identify a first operating frequency, based on information related to an operating frequency received from the electronic device, controlling to drive the at least one delay, based on the first operating frequency, adjusting switching timing of at least two switches among the plurality of switches with a delay value of the at least one delay, and controlling switching of the plurality of switches, based on the adjusted switching timing. Other embodiments are also possible.

## Description

### [Technical Field]

The disclosure relates to an electronic device and a method for wireless charging supporting multiple frequencies.

### [Background Art]

With the development of wireless charging technology, methods for charging various electronic devices by supplying power with a single charging device are being studied. This wireless charging technology uses wireless power transmission and reception, and is a system that can charge a battery, for example, by simply placing an electronic device on a charging pad without connecting the electronic device with a separate charging connector.

The wireless charging technology include an electromagnetic induction method, a resonance method using resonance, or an RF/microwave radiation method that converts electrical energy into microwaves and transmits the microwaves.

The power transmission method by wireless charging is a method of transmitting power between a first coil of a transmitting end and a second coil of the receiving end. A magnetic field is generated at the transmitting end, and current is induced or resonates according to changes in the magnetic field at the receiving end to generate energy.

Wireless power transmission technology using electromagnetic induction is a method of transmitting power using the electromagnetic field induced in a coil, and an external electronic device generates an electromagnetic field by applying a current to the coil, and the generated electromagnetic field generates an induced electromotive force in the coil of the electronic device, allowing power to be transmitted wirelessly.

### [Detailed Description of the Invention]

### [Technical Solution]

Qi-based wireless charging is performed in a limited frequency range of 110kHz to 145kHz. In addition to the 110~145kHz operating frequency, a higher operating frequency(e.g. 350kHz) can be used. The resonance capacitor is set to match the Qi wireless charging operating frequency, but when the resonance capacitor operates at the high operating frequency(e.g. 350kHz), the efficiency of wireless charging may be reduced. To this end, in order to support both operating frequencies in the 110~145kHz and 350kHz bands, an additional circuit may be needed in the Rx part that allows the resonance capacitor (e.g. a characteristic thereof) to be changed depending on the operating frequency.

To support multiple operating frequencies, a circuit that changes the resonance capacitor using a switch is required, which increases printed circuit board (PCB) area and material costs. In particular, when the power of wireless charging is large, the voltage applied to the capacitor is large, so a MOSFET (metal oxide semiconductor field effect transistor) with a large BV may be needed. However, in an electronic device where PCB area is important (e.g. limiting the size of the PCB area and/or an amount of free space on the PCB area), it may be difficult to use a circuit that changes the resonance capacitor.

The disclosure is made to provide an electronic device, method, and non-transitory storage medium for efficient wireless charging when the electronic device for receiving wireless power does not include an additional circuit for changing a resonant capacitor in a resonant circuit and the operating frequency is changed using the switching operation of the rectifier circuit without changing the resonant capacitor.

According to an embodiment of the disclosure, an electric device may include a resonance circuit including a coil configured to wirelessly receive power from an external electronic device and a first capacitor, a rectifier circuit connected to the resonance circuit, a communication circuit, and a control circuit electrically connected to the rectifier circuit, the resonance circuit, and the communication circuit.

According to an embodiment, the rectifier circuit may include a plurality of switches (e.g. S1, S2, S3, and S4), a plurality of switch driver each circuits electrically connected to one of the plurality of switches, and at least two switch driver circuits among the plurality of switch driver circuits may be included at least one delay.

According to an embodiment, the control circuit may be configured to identify a first operating frequency, based on information related to an operating frequency received from the external electronic device.

According to an embodiment, based on the first operating frequency, the control circuit may be configured to control at least one delay to operate, and adjust switching timing of at least two switches among the plurality of switches with a designated delay value of the at least one delay.

According to an embodiment, based on identifying that the operating frequency is not changed, the control circuit may be configured to control the at least one delay not to operate and control switching operations of the plurality of switches.

According to an embodiment, a method of operating in an electronic device may include identifying a first operating frequency, based on information related to the operating frequency received from an external electronic device.

The method may include driving at least one delay included in a rectifier circuit of the electronic device, based on the first operating frequency.

According to an embodiment, the method may include adjusting switching timing of at least two switches among the plurality of switches included in the rectifier circuit with a delay value of the at least one delay.

According to an embodiment, the method may include performing switching of the plurality of switches, based on the adjusted switching timing.

According to an embodiment, the plurality of switches may be each electrically connected to one of the plurality of switch drivers included in the rectifier circuit. According to an embodiment, at least two switch driver circuits of the plurality of switch driver circuits may be included the at least one delay.

According to an embodiment, in a non-transitory storage medium for storing program, the program may include instructions configured to, when executed by a processor of an electronic device, cause the electronic device to execute identifying a first operating frequency, based on information related to the operating frequency received from an external electronic device, based on the first operating frequency, driving at least one delay included in a rectifier circuit of the electronic device, adjusting switching timing of at least two switches among a plurality of switches included in the rectifier circuit with a delay value designated of at least one delay and performing switching of the plurality of switches, based on the adjusted switching timing. According to an embodiment, the plurality of switches may be each electrically connected to one of the plurality of switch drivers, and at least two switch driver circuits of the plurality of switch driver circuits may be included the at least one delay.

### [Brief Description of Drawings]

FIG. 1 is a block diagram of an electronic device in a network environment according to various embodiments.
FIGS. 2A and 2B are diagrams illustrating an external electronic device for transmitting wireless power and an electronic device for receiving wireless power, according to an embodiment.
FIG. 3 is a diagram illustrating an example of a configuration of an electronic device according to an embodiment.
FIG. 4 is a diagram for comparing an operation waveform of an electronic device according to an embodiment and a conventional operation waveform.
FIG. 5 is a diagram illustrating an example of an operation method in an electronic device according to an embodiment.

With regard to the description of the drawings, the same or like reference signs may be used to designate the same or like elements.

### [Mode for Carrying out the Invention]

Hereinafter, embodiments of the disclosure will be described in detail with reference to the drawings so that those skilled in the art to which the disclosure pertains can easily implement the disclosure. However, the present disclosure may be implemented in various forms and is not limited to embodiments set forth herein. With regard to the description of the drawings, the same or like reference signs may be used to designate the same or like elements. Also, in the drawings and the relevant descriptions, description of well-known functions and configurations may be omitted for the sake of clarity and brevity. As used in various embodiments, the term "user" may refer to a person who uses an electronic device or a device (e.g., artificial intelligence electronic device) which uses an electronic device.

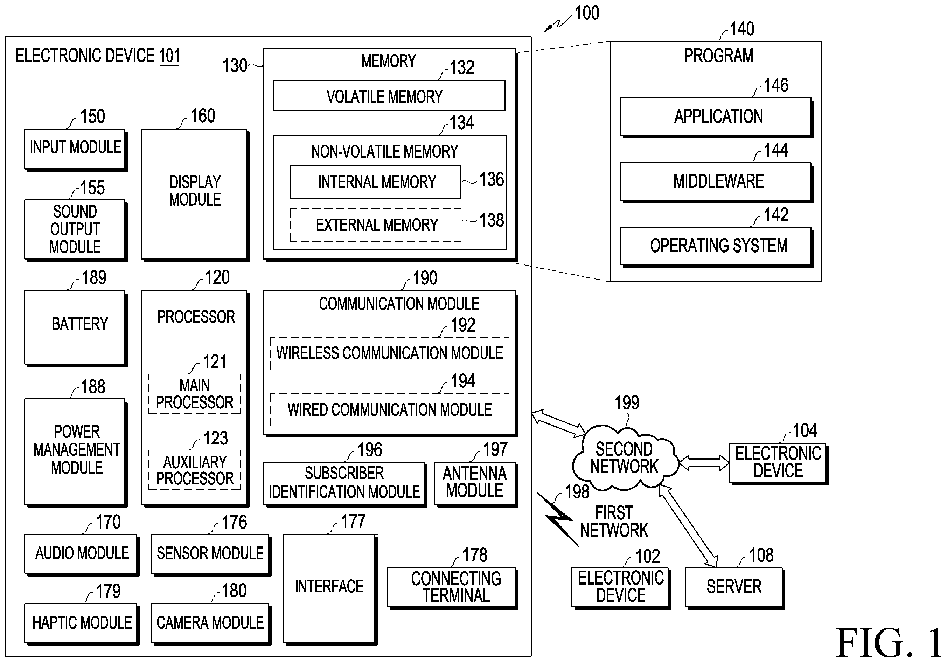

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing 1eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

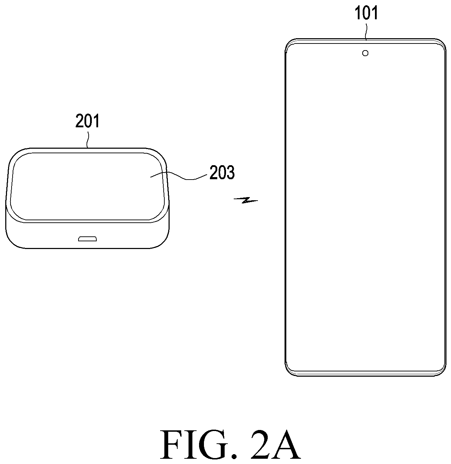

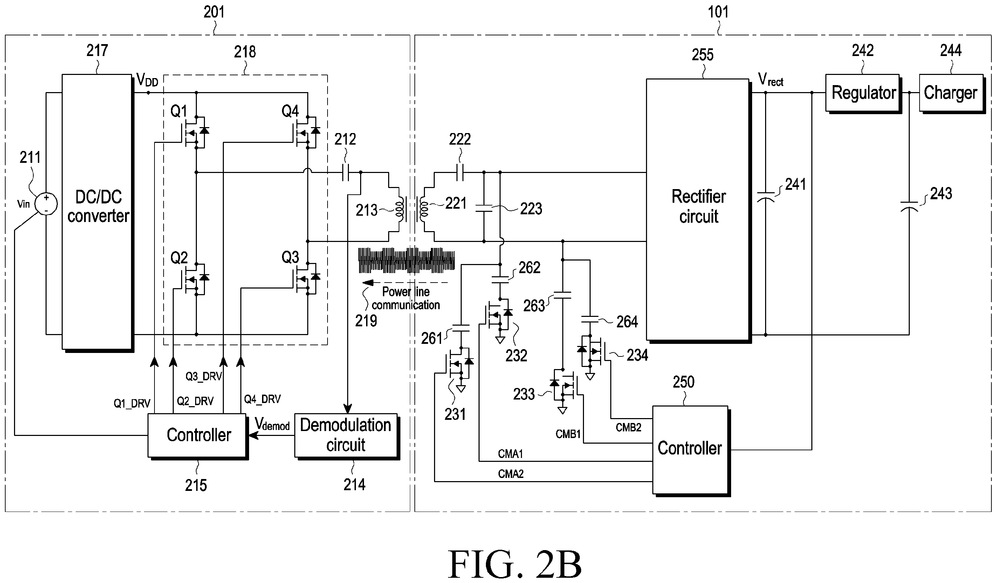

Hereinafter, in the description according to an embodiment referring to FIGS. 2A to 3, a device for transmitting wireless power (e.g., a wireless power transmitting device) may be referred to as an external electronic device, and a device for receiving wireless power (e.g., a wireless power receiving device) may be referred to as an electronic device. FIGS. 2A and 2B are diagrams illustrating an external electronic device for transmitting wireless power and an electronic device for receiving wireless power according to an embodiment.

Referring to FIGS. 2A and 2B, the external electronic device 201 (e.g., the electronic device 102 in FIG. 1) for transmitting wireless power according to an embodiment may wirelessly transmit power to an electronic device 101 (e.g., the electronic device 101 in FIG. 1) for receiving wireless power. For example, the external electronic device 201 may receive information from the electronic device 101. In an example, the external electronic device 201 may transmit power according to an inductive method. When the external electronic device 201 transmits, or is to transmit, power by the induction method, the external electronic device 201 may include at least one of, for example, a power source, a direct current-direct current conversion circuit (e.g., DC/DC converter), a direct current-alternating current conversion circuit (e.g., inverter), an amplification circuit, an impedance matching circuit, at least one capacitor, at least one coil, or a communication modulation circuit. For example, at least one capacitor may form a resonance circuit with at least one coil. For example, the external electronic device 201 may implement at least a portion of the method defined in the Qi standard of the wireless power consortium (WPC). The external electronic device 201 may include a coil that can generate an induced magnetic field when current flows according to the induction method. The process in which the external electronic device 201 generates the induced magnetic field may be expressed as the external electronic device 201 transmitting power wirelessly. In addition, in the coil of the electronic device 101, induced electromotive force (e.g., current, voltage, and/or power) may be generated by the magnetic field generated around the coil according to the resonance method or the induction method. The process of generating the induced electromotive force through the coil may be expressed as the electronic device 101 receiving power wirelessly.

The external electronic device 201 according to an embodiment may communicate with the electronic device 101. For example, the external electronic device 201 may communicate with the electronic device 101 according to an in-band method. The external electronic device 201 may modulate data to be transmitted according to, for example, a frequency shift keying (FSK) modulation method, and the electronic device 101 may perform modulation according to an amplitude shift keying (ASK) modulation method to provide information. The external electronic device 201 may identify the information provided by the electronic device 101, based on the amplitude of the current and/or voltage applied to the coil. In the description of FIG. 2, the electronic device 101 is shown as transmitting information directly to the external electronic device 201, but this is only for ease of understanding, and those skilled in the art will understand that the electronic device 101 controls on/off of at least one switch therein. The operation of performing modulation, based on the ASK modulation method and/or the FSK modulation method may be understood as an operation of transmitting data (or packets) according to the in-band communication method, and the operation of performing demodulation, based on the ASK demodulation method and/or the FSK demodulation method may be understood as an operation of receiving data (or packets) according to the in-band communication method.

In the disclosure, the external electronic device 201 or the electronic device 101 performing a specific operation may mean that various hardware included in the external electronic device 201 or the electronic device 101, for example, a controller (e.g., micro controlling unit (MCU), field programmable gate array (FPGA), application specific integrated circuit (ASIC), microprocessor, or application processor (AP)) performs a specific operation. Alternatively, the external electronic device 201 or the electronic device 101 performing a specific operation may mean that the controller controls other hardware to perform the specific operation. Alternatively, the external electronic device 201 or the electronic device 101 performing a specific operation may mean that, as at least one instruction for performing the specific operation stored in a storage circuit (e.g., memory) of the external electronic device 201 or the electronic device 101 is executed, causing the controller or other hardware to perform the specific operation.

In the disclosure, the electronic device 101 may be a foldable or flip-type electronic device in which a portion of the housing is folded, and include a hinge structure made of metal disposed at the folded portion of the housing.

The external electronic device 201 according to an embodiment may perform ping, identification and configuration, negotiation for FOD determination, and power transfer operations to transmit power to the electronic device 101 according to a method defined in the Qi standard of the wireless power consortium (WPC).

The external electronic device 201 according to an embodiment may include at least one of a power source 211, an inverter 218 including a plurality of switches Q1, Q2, Q3, and Q4 (it will be appreciated that the number of switches shown in FIG. 2A should not be seen as limiting), a capacitor 212, a coil 213, a demodulation circuit 214, a controller 215, or a DC/DC converter (217). According to an embodiment, the power provided by the power source 211 may be provided to the DC/DC converter 217. The power source 211 may include at least one of an interface for being connected to an external travel adapter (TA), a battery (not shown), a charger (not shown), or a power management integrated circuit (PMIC) (not shown) of the external electronic device 201. The power source 211 may, for example, provide direct current power to the DC/DC converter 217, but there is no limitation on the form of power provided. The DC/DC converter 217 may convert the voltage of the received power to apply the voltage to the inverter 218. The DC/DC converter 217 may change the voltage of the applied DC power to provide the DC power with the changed voltage (or driving voltage VDD) to the inverter 218. The DC/DC converter 217 may perform, for example, buck conversion and/or boost conversion, and may be implemented as a 3-level converter, but those skilled in the art will understand that there is no limit to the type.

The inverter 218 according to an embodiment may output alternating current power using the driving voltage VDD provided from the DC/DC converter 217. The plurality of switches Q1, Q2, Q3, and Q4 may form a full bridge circuit, for example, but there is no limit to the number of switches or the type of bridge circuit. For example, when the full bridge circuit is formed, one end of the coil 213 may be connected to a connection point between the switches Q1 and Q2 through the capacitor 212, and the other end of the coil 213 may be connected to a connection point between the switches Q3 and Q4. The plurality of switches Q1, Q2, Q3, and Q4 may be controlled to be in an on or off state. For example, in order to generate alternating current power, the controller 215 may control the first switch Q1 and the third switch Q3 to be in the on state while controlling the second switch Q2 and the fourth switch Q4 to be in the off state during a first period, control the first switch Q1 and the third switch Q3 to be in the off state while controlling the second switch Q2 and the fourth switch Q4 to be in the on state during a second period, and the described control operations may be performed repeatedly. The controller 215 may provide control signals Q1_DRV, Q2_DRV, Q3_DRV, and Q4_DRV for generating the above-described AC power to the plurality of switches Q1, Q2, Q3, and Q4. Here, not only outputting the control signal but also refraining from outputting the control signal may be referred to as control of the controller 215. In other words, outputting the control signal is an example of an operation of the controller 215, and refraining from outputting (e.g. holding output, not outputting etc.) the control signal is also an example of an operation of the controller 215. For example, the controller 215 outputting a first control signal for generating the AC power having a first frequency to the inverter 218 may mean that the controller 215 outputs the control signals Q1_DRV and Q3_DRV for controlling the switches Q1 and Q3 to be in the on state during a first period corresponding to the first frequency, thereafter, outputs the control signals Q2_DRV and Q4_DRV for controlling the switches Q2 and Q4 in the on state during a second period corresponding to the first frequency, and repeats the output operations. Meanwhile, the controller 215 outputting a second control signal for generating the AC power having a second frequency to the inverter 218 may mean that the controller 215 outputs the control signals Q1_DRV and Q3_DRV for controlling the switches Q1 and Q3 in the on state during a first period corresponding to the second frequency, thereafter, outputs the control signals Q2_DRV and Q4_DRV for controlling the switches Q2 and Q4 to be in the on state for a second period corresponding to the second frequency, and repeats the output operations. In this case, the first period and second period corresponding to the second frequency may be different from the first period and second period corresponding to the first frequency. At least one of the DC/DC converter 217 or the inverter 218 may be referred to as a power supply circuit. The controller 215 may control the power supply circuit (e.g., at least one of the DC/DC converter 217 or the inverter 218) so that power is applied to the coil 213.

According to an embodiment, the alternating current power generated by the inverter 218 may be applied to the coil 213. The inverter 212 may form a resonance circuit with the coil 213. The coil 213 may form a magnetic field, based on the applied alternating current power. A portion of the magnetic field (or magnetic flux) formed by the coil 213 may pass through the cross section of the coil 221 of the electronic device 101. As the magnetic field passing through the cross section of the coil 221 changes over time, induced electromotive force (e.g., current, voltage, or power) may be generated in the coil 221.

According to an embodiment, the demodulation circuit 214 may demodulate a signal applied to the coil 213 (e.g., the voltage 219 applied to both ends of the coil 213) to output a demodulation signal Vdemod. The demodulation circuit 214 may output the demodulation signal Vdemod by down-converting the frequency (e.g., 100 to 210 kHz) of the alternating current power, for example, for the signal applied to the coil 213 (e.g., voltage 219 at both ends). For example, the demodulation circuit 214 may include a mixer and/or a multiplier circuit to remove the carrier wave component (e.g., 100 to 210 kHz, which is the frequency of alternating current power) for wireless power transmission. Here, a waveform that is a mixture of the modulation component of the electronic device 101 and the alternating current power component generated by the external electronic device 201 may be applied to both ends of the coil 213 of the external electronic device 201. Accordingly, the frequency component (e.g., 100 to 210 kHz) of the alternating current power is called the carrier wave component, and those skilled in the art will understand that the electronic device 101 does not actually generate electromagnetic waves by mixing modulated data with the carrier wave. Accordingly, the carrier wave component (e.g., 100 to 210 kHz, which is the frequency of alternating current power) may be removed from the voltage 219 across the coil 213. The demodulation circuit 214 may additionally filter (low-pass filter) the demodulation signal Vdemod to output a filtered demodulation signal Vdemod. The demodulation circuit 214 may include a low-pass filter. Alternatively, the demodulation circuit 214 may generate the demodulation signal Vdemod by filtering the voltage 219 across the coil 213 and then down-converting the frequency (e.g., 100 to 210 kHz) of the alternating current power. An amplitude of the voltage 219 across the coil 213 may change according to the ASK modulation of the electronic device 101. According to an embodiment, the controller 215 may identify information provided by the electronic device 101, based on the demodulation signal Vdemod output by the demodulation circuit 214. The controller 215 may, for example, perform analog-to-digital converting (ADC) on the demodulation signal Vdemod. The controller 215 may decode a digital value obtained as a result of the ADC, and identify the information provided by the electronic device 101 according to the decoding result. The decoding method may be, for example, based on the Qi standard, but those skilled in the art will understand that there are no limitations. Meanwhile, in the above-described embodiment, the demodulation circuit 214 is described as performing frequency down-conversion (e.g., carrier rejection) and/or low-pass filtering, and the controller 215 is described as performing ADC and/or decoding, but this is merely illustrative. Those skilled in the art will appreciate that the demodulation circuit 214 may be implemented to further perform at least one of ADC or decoding, and may be implemented such that the controller 215 may further perform frequency down-conversion (e.g., carrier rejection) and/or low-pass filtering.

According to an embodiment, the electronic device 101 may include at least one of the coil 221, a capacitor (e.g., a first capacitor) 222, a capacitor (e.g., second capacitor) 223, a rectifier circuit 255, a controller 250, a plurality of capacitors 261, 262, 263, and 264 (it will be appreciated that the number of capacitors shown in FIG. 2A should not be seen as limiting), a plurality of switches 231, 232, 233, and 234 (it will be appreciated that the number of switches shown in FIG. 2A should not be seen as limiting), a capacitor 241, a regulator 242, a capacitor 243, or a charger 244.

According to an embodiment, the coil 221, the capacitor 222, and the capacitor 223 may form a resonance circuit. One end of the capacitor 222 may be connected to the coil 221, and the other end of the capacitor 222 may be connected to one end of the capacitor 223 and one end of the rectifier circuit 255. One end of the capacitor 223 may be connected to the other end of the capacitor 222, and the other end of the capacitor 223 may be connected to the other end of the coil 221. In other words, the capacitor 223 may be connected in parallel to a circuit formed by connecting the coil 221 and the capacitor 222 in series. The other end of the capacitor 223 may be connected to the other end of the rectifier circuit 255.

According to an embodiment, the rectifier circuit 255 may convert alternating current power received through the coil 221 into direct current power. The controller 250 (e.g., a control circuit) may control the on/off states of the plurality of switches S1, S2, S3, and S4 so that the alternating current power may be converted into the direct current power.

According to an embodiment, the capacitor 241 and the regulator 242 may be connected to the rectifier circuit 255. One end of the capacitor 241 may be grounded. The regulator 242 may perform conversion (e.g., buck conversion and/or boost conversion) and/or regulation of the voltage of the rectified power output from a power conversion circuit.

According to an embodiment, the charger 244 (e.g., charging circuit and/or power management circuit) may charge a battery (not shown) using the power converted and/or regulated by the regulator 242. According to an embodiment, the charger 244 may control the voltage and/or current for charging the battery depending on the battery's charging mode (e.g., constant current (CC) mode, constant voltage (CV) mode, or fast charge mode). Depending on the implementation, a PMIC (not shown) may be connected to the regulator 242 in place of the charger 244.

According to an embodiment, the controller 250 may perform modulation in response to information to be provided. The controller 250 may determine a capacitor to perform modulation among the plurality of capacitors 261, 262, 263, and 264. The difference in amplitude of the voltage 219 sensed by the external electronic device 201 may be changed depending on the capacitor that performs modulation. For example, when modulation is performed with only the capacitor 261, it is assumed that the difference in amplitude of the voltage 219 sensed by the external electronic device 201 (e.g., the difference between the maximum amplitude of voltage 219 while switch 231 is on and the maximum amplitude of voltage 219 while switch 231 is off) is a first value. In this case, because the capacitors 262, 263, and 264 are not used for modulation, the switches 232, 233, and 234 may remain in the off state. Meanwhile, when modulation is performed with the capacitor 261 and the capacitor 262, the difference in amplitude of the voltage 219 sensed by the external electronic device 201 (e.g., the difference between the maximum amplitude of voltage 219 while switches 231 and 232 are on and the maximum amplitude of voltage 219 while switches 231 and 232 are off) is a second value, which may be greater than the first value. In this case, because the capacitors 263 and 264 are not used for modulation, the switches 233 and 234 may remain in the off state. The electronic device 101 may adjust a modulation degree (or modulation depth) by adjusting the capacitor to perform modulation among the plurality of capacitors 261, 262, 263, and 264. As described above, the controller 250 may output and/or refrain from outputting at least some of the control signals CMA1, CMA2, CMB1, and CMB2 while performing modulation using the determined capacitor so that the switch corresponding to the undetermined capacitor remains in the off state. Meanwhile, for example, the capacitance of the capacitor 262 may be smaller than the capacitance of the capacitor 261, and the capacitance of the capacitor 264 may be smaller than the capacitance of the capacitor 263, but this is a simple example and there is a limit to the magnitude of the capacitances, and the capacitances may be the same.

The controller 215 described in FIG. 2B above may be referred to as a control circuit, and may be a micro controlling unit (MCU), a field programmable gate array (FPGA), an application specific integrated circuit (ASIC), and at least one processor or an application processor (AP).

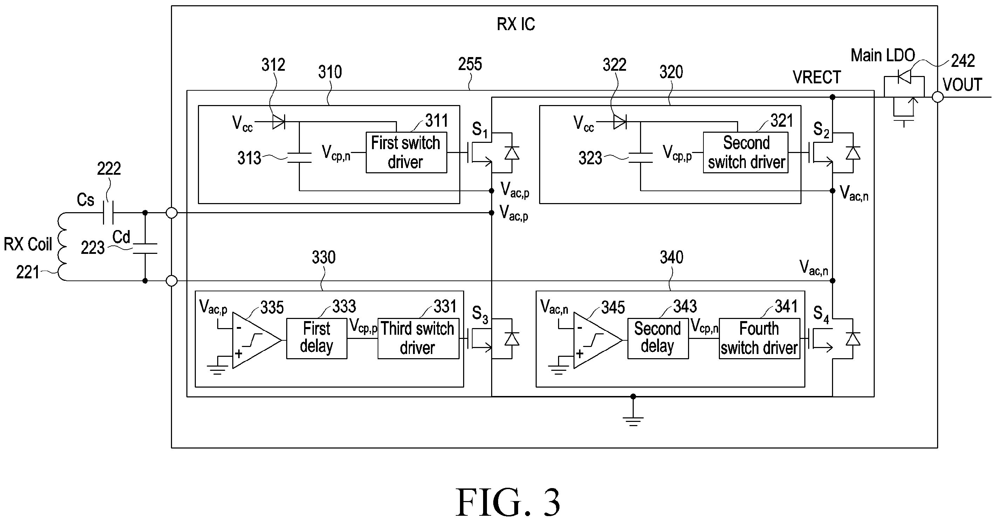

FIG. 3 is a diagram illustrating an example of a configuration of an electronic device according to an embodiment.

Referring to FIGS. 2A, 2B, and 3, the electronic device 101 (e.g., the electronic device 101 in FIGS. 1 and 2A) may be configured to support multiple operating frequencies (e.g., a first operating frequency (e.g. operating frequency in the 350 kHz band) and a second operating frequency (e.g. operating frequency in the 110-145 kHz band), and may include a resonance circuit - including a coil 221, a first capacitor 222, and a second capacitor 223 - that wirelessly receives power from a wireless charging transmitter 201 (e.g., the electronic device 201 in FIG. 2A), a rectifier circuit 255 connected to the resonant circuit, a communication circuit (e.g., communication circuit 190 in FIG. 1) and a rectifier circuit 255, a control circuit electrically connected to the resonance circuit and the communication circuit (e.g., processor 120 in FIG. 1). In various examples, the rectifier circuit 255 and the control thereof are considered without explicit reference to any other component of the electronic device; e.g. it is implicit that there is control circuitry and a circuitry receiving power wirelessly.

According to an embodiment, the rectifier circuit 255 may include a plurality of switches S1, S2, S3, and S4 (e.g., four diodes or transistors) forming a full bridge circuit and a plurality of switch driver circuits electrically connected to the plurality of switches, respectively. One end of the resonance circuit may be connected to a connection point between the switches S1 and S2, and the other end of the resonance circuit may be connected to a connection point between the switches S3 and S4. The rectifier circuit 255 may rectify (e.g., convert to direct current (DC)) the wireless power (e.g., alternating current (AC) power) received from the coil 221, and may apply the rectified power to a charger (e.g., the charger 244 in FIG. 2B, a charging circuit, and/or a power management circuit) through the regulator (e.g., main LDO) 242.

According to an embodiment, an input end of the rectifier circuit 255 may be connected in parallel with the second capacitor (e.g. Cd) 223, the controller 250 may be connected to the input end, and the regulator 242 may be connected to an output end. According to an embodiment, one end of the second capacitor 223 may be connected to the first capacitor 222 (e.g., resonance capacitor Cs). According to an embodiment, one end of the first capacitor 222 may be connected to the coil 221, and the other end may be connected to the second capacitor 233. Without being limited thereto, the rectifier circuit 255 may separately form a plurality of switch driver circuits included in the rectifier circuit 255, and may be called a 'rectifier circuit' including the plurality of switches S1, S2, S3, and S4. Here, the rectifier circuit 255 and the regulator 242 may be referred to as a 'receiving integrated circuit (e.g., RX IC)'.

According to an embodiment, the plurality of switch driver circuits may include a first switch driver circuit 310, a second switch driver circuit 320, a third switch driver circuit 330, and a fourth switch driver circuit 340. For example, the first switch driver circuit 310 may be connected to the first switch S1, the second switch driver 320 may be connected to the second switch S2, the third switch driver 330 may be connected to the third switch S3, and the fourth switch driver 340 may be connected to the fourth switch (S4).

According to an embodiment, the first switch driver circuit 310 may have one end (e.g., input terminal) connected to the coil 221 and a + terminal (e.g., P terminal) of the second capacitor 223 and the other end (e.g., output end) connected to the first switch S1, and may include a first switch driver 311, a diode 312, and a capacitor 313. A first voltage (e.g., Vac, p) may be applied to one end of the first switch driver circuit 310, and the first switch driver circuit 310 may output an enable signal to the first switch S1 connected to the other end, based on a designated delay value (e.g., the output voltage Vcp, n of a second delay 343). A third voltage Vcp, n (e.g., the output voltage of a second delay 343) may be applied to one end of the first switch driver 311.

According to an embodiment, the second switch driver circuit 320 may have one end connected to the coil 221 and a - terminal (e.g., n terminal) of the second capacitor 223 and the other end connected to the second switch S2, and may include a second switch driver 321, a diode 322, and a capacitor 323. A second voltage (e.g., Vac, n) may be applied to one end of the second switch driver circuit 320, based on the second voltage being applied to one end of the second switch driver circuit 320, and an enable signal may be output to the second switch S2 connected to the other end, based on a designated delay value (e.g., output voltage Vcp, p of the first delay 333). A fourth voltage Vcp, p (e.g., the output voltage of the first delay 333) may be applied to the second switch driver 311.

According to an embodiment, one end of the third switch driver circuit 330 may be connected to the coil 221 and a + terminal (e.g., P terminal) of the second capacitor 223 (not illustrated in FIG. 3) and the other end connected to the third switch S3, and may include a third switch driver 331, a first delay 333, or a first comparator 335. The first delay 333 may be located between the third switch driver 331 and the first comparator 335. Based on the first voltage being applied, the third switch driver circuit 330 may delay for a delay time set based on the delay value Vcp, p designated by the first delay 333, and then output the enable signal to the third switch S3 by the third switch driver 331. The output voltage Vcp, p of the first delay 333 may be applied to the second switch driver 321. One end of the first comparator 335 may be connected to the coil 221 and the + terminal (e.g., P terminal) of the second capacitor 223, and the other end may be connected to ground. According to an embodiment, as the switching operation is performed after a predetermined time delay (e.g., switching delay), based on the delay value output by the first delay 333, for example, the same effect can be obtained as when a capacitor and a resistor R are connected in series in an equivalent circuit.

According to an embodiment, the fourth switch driver circuit 340 may have one end connected to both ends of the second capacitor 223 (not illustrated in FIG. 3) and the other end connected to the fourth switch S4, and may include a fourth switch driver 341, a second delay 343, and a second comparator 345. The second delay 343 may be configured between the fourth switch driver 341 and the second comparator 345. Based on the second voltage being applied to one end, the fourth switch driver circuit 340 may delay for a delay time corresponding to the delay value designated by the second delay 343, and then output an enable signal to the fourth switch S4. The output voltage Vcp, n of the second delay 343 may be applied to the first switch driver 311. One end of the second comparator 345 may be connected to the coil 221 and a - terminal (e.g., n terminal) of the second capacitor 223, and the other end may be connected to ground. According to an embodiment, as the switching operation is performed after a predetermined time delay (e.g., switching delay), based on the delay value output by the second delay 343, for example, the same effect can be obtained as when a capacitor and a resistor R are connected in series in an equivalent circuit.

According to an embodiment, the plurality of switches S1, S2, S3, and S4 may form a full bridge circuit. One end of the first switch S1 and one end of the second switch S2 may be connected to the regulator 242, one end of the third switch S3 may be connected to the other end of the first switch S1, and one end of the fourth switch S4 may be connected to the other end of the second switch S2. The other end of the third switch S3 and the other end of the fourth switch S4 may be connected to ground. The other end of the first switch S1 and the one end of the third switch S3 may be connected to one end of each of the first capacitor 222 (Cs) and the second capacitor 223 (Cd), and the one end of the fourth switch S4 and the other end of the second switch S2 may be connected to the other end of the coil 221 and the other end of the second capacitor 223 (Cd).

According to an embodiment, the controller 250 (e.g., control circuit) may receive information related to an operating frequency received through the communication circuit 190 (or otherwise obtain the information related to an operating frequency, such as via a memory of the electronic device 101 or from an external source other than the external electronic device 201) and identify (e.g. detect, determine etc.) the operating frequency, based on the information related to the operating frequency. In various examples, more generally, the controller 250 identifies an operating frequency or an indication thereof. In an embodiment, the controller 250 may detect the operating frequency, based on the voltage Vac of the signal induced in the coil 221. The control circuit 250 may control at least one delay (e.g., the first delay 333 and/or the second delay 343) to operate, based on the identified operating frequency, and may adjust (e.g. modify, change, set, control etc.) the switching timing of at least two switches (e.g., the third switch S3 or/and the fourth switch S4) each connected to the at least two switch driver circuits with the designated delay value of the delay. In various examples, the controller 250 detects that (e.g. whether, if etc.) that the operating frequency is a first operating frequency, and adjusts the switching timing with the delay value of the delay accordingly; and/or, if the operating frequency is a second operating frequency, the controller 250 performs switching (or controls a switching operation of the switches) without driving the delay.

According to an embodiment, the controller 250 may delay a certain period of time, based on the delay value output by the second delay 343 included in the fourth switch driver circuit 340, and then, control the first switch S1 and the fourth switch S4 to be turned on and the second switch S2 and the third switch S3 to be turned off during a first period, based on the enable signal being output from the first switch driver circuit 310 and the fourth switch driver circuit 340.

According to an embodiment, the controller 250 may delay a certain period of time, based on the delay value output by the first delay 333 included in the third switch driver circuit 330, and then, control the second switch S2 and the third switch S3 to be turned on and the first switch S1 and the fourth switch S4 to turned off during a second period, based on the enable signal being output from the second switch driver circuit 320 and the third switch driver circuit 330.

According to an embodiment, the regulator 242 may convert the voltage VRECT rectified in the rectifier circuit 255 into a certain direct current voltage (DC voltage) and transmit power to the charger. The regulator 240 may be configured to be electrically connected to the rectifier circuit 255 and the controller 250.

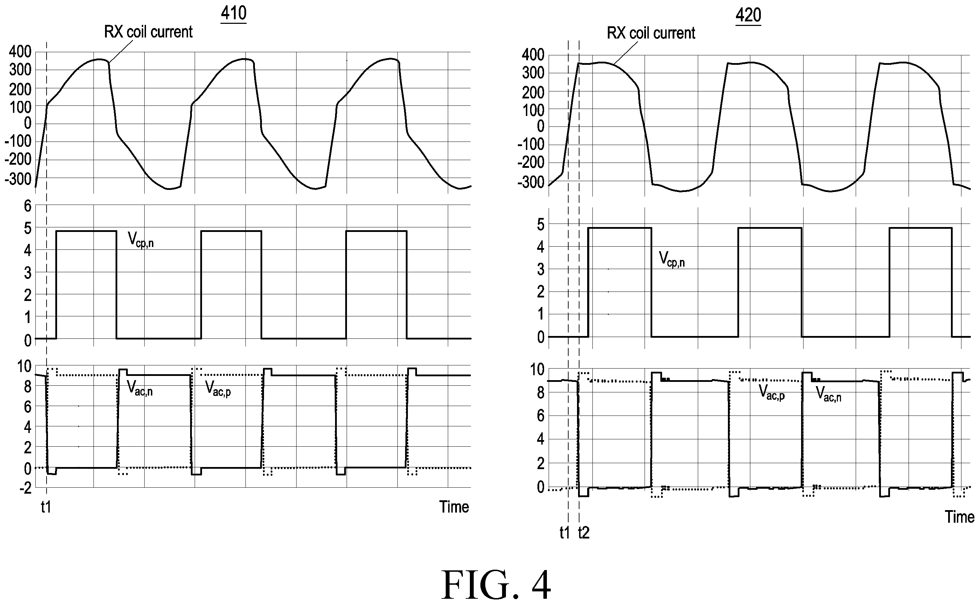

FIG. 4 is a diagram for comparing an operation waveform of an electronic device according to an embodiment and a conventional operation waveform.

Referring to FIGS. 2A, 2B, and 4, due to the switching operation of the rectifier circuit 255 of the electronic device 101 according to an embodiment, an operation waveforms 420 may be output by delaying current (RX coil current) and/or voltages (e.g., Vcp, n, Vac, n, and Vac, p) from time t1 to time t2, compared to the conventional comparative operation waveforms 410. As a result, a phase difference occurs between the current and the input end (AC end) voltage, which has the same effect as reducing the resonance capacitance value.

The electronic device 101 according to an embodiment might not include an additional circuit for changing the resonance capacitor in the resonance circuit, and efficient wireless charging may be possible when the operating frequency is changed using the switching operation of the rectifier circuit 255 even without changing the resonance capacitor.

The electronic device 101 according to an embodiment may have the same effect as reducing the resonance capacitance due to the phase difference between the current and the input end (AC end) voltage through the switching operation in the rectifier circuit 255, so that the electronic device 101 of the disclosure can increase efficiency depending on the operating frequency (e.g., switching frequency).

**[Table 1]**

| | Case 1 | Case 2 | Case 3 | Case of the disclosure |
|---|---|---|---|---|
| Switching frequency | 145kHz | 350kHz | 350kHz | 350kHz |
| Cs | 147nF | 147nF | 27nF | 147nF |
| Prog. delay | 0s | 0s | 0s | 150ns |
| Simulation efficiency | 77.23% | 75.91% | 82.65% | 79.77% |

As shown in <Table 1>, in the comparative cases (case1, case2, case3), when the switching frequency is changed, for example, from 145 kHz to 350 kHz, and the value of the first capacitor 222 (Cs) is changed, for example, from 147 nF to 27 nF, and there is no delay (e.g., a delay time of 0 s), it can be seen that the simulation efficiency increases to, for example, approximately 82.65%. In comparison, according to an embodiment of the disclosure (case of the disclosure), when the electronic device 101 supports both the first operating frequency (e.g., 350 kHz) and the second operating frequency (e.g., 110 kHz to 145 kHz), and the switching frequency is changed to, for example, 350 kHz, it can be seen that the switching operation is delayed by a specified delay value (prog. delay) (e.g., 150 ns) by operating the delay, thereby increasing the simulation efficiency to, for example, approximately 79.77%. Not limited thereto, <Table 1> above is an example identified through experiment, and simulation efficiency may be calculated at different values depending on device characteristics (e.g., type or performance). For example, when the electronic device 101 uses only the first operating frequency (e.g., 350 kHz), the delay may always be operated in an on state.

According to an embodiment, an electronic device (e.g., the electronic device 101 in FIG. 1, the electronic device 101 in FIGS. 2A and 2B) may include a resonance circuit including a coil 221 configured to wirelessly receive power from an external electronic device (e.g., the wireless charging transmitter 201 of FIGS. 2A and 2B) and a first capacitor 222, a rectifier circuit (e.g., rectifier circuit 255 in FIGS. 2A and 3) connected to the resonance circuit, a communication circuit (e.g., communication module 190 of FIG. 1), and a control circuit (e.g., processor in FIG. 1, controller 250 in FIG. 2A) electrically connected to the rectifier circuit, the resonance circuit, and the communication circuit.

According to an embodiment, the rectifier circuit may include a plurality of switches S1, S2, S3, and S4 and a plurality of switch driver circuits (e.g., a plurality of switch driver circuits 310, 320, 330, 340 in FIG. 3) each electrically connected to one of the plurality of switches, and at least two switch driver circuits among the plurality of switch driver circuits may be included at least one delay.

According to an embodiment, the control circuit may be configured to identify a first operating frequency, based on information related to an operating frequency received from the external electronic device.

According to an embodiment, the control circuit may be configured to control to drive the at least one delay, based on the first operating frequency, and adjust switching timing of at least two of the plurality of switches with a designated delay value of the at least one delay.

According to an embodiment, the control circuit may be configured to identify a second operating frequency, based on the information related to the frequency, control the at least one delay not to operate, based on the second operating frequency, and control switching operations of the plurality of switches.

According to an embodiment, the control circuit may be configured to control the rectifier circuit to turn on the at least two switches each connected to the at least two switch driver circuits with the adjusted switching timing.

According to an embodiment, the electronic device may further include a regulator connected to output ends of at least two switches among the plurality of switches.

According to an embodiment, the resonance circuit may further include a second capacitor, the first capacitor may have one end connected to the coil and the other end connected to the second capacitor, and the second capacitor may have one end connected in series to the other end of the first capacitor, the other end connected to the coil, and connected in parallel to the rectifier circuit.

According to an embodiment, the plurality of switch driver circuits may include a first switch driver circuit (e.g., the first switch driver circuit 310 in FIG. 3), a second switch driver circuit (e.g., the second switch driver circuit 320 in FIG. 3), a third switch driver circuit (e.g., the third switch driver circuit 330 in FIG. 3), and a fourth switch driver circuit (e.g., the fourth switch driver circuit 340 in FIG. 3).

According to an embodiment, the plurality of switches may include a first switch(S1), a second switch(S2), a third switch(S3), and a fourth switch(S4), and may be configured as a full bridge circuit.

According to an embodiment, the first switch driver circuit may include a first switch driver, the second switch driver circuit may include a second switch driver, the third switch driver circuit may include a third switch driver, a first comparator, and a first delay, the first delay may be configured between the second switch driver and the first comparator, the fourth switch driver circuit may include a fourth switch driver, a second comparator, and a second delay, and the second delay may be configured between the fourth switch driver and the second comparator.

According to an embodiment, based on a first voltage (Vac, p) being applied to one end of the first switch driver circuit, after delaying, based on a second delay value output by the second delay, the first switch driver circuit may output a first enable signal to the first switch connected to the other end of the first switch driver circuit.

According to an embodiment, based on a second voltage (Vac, n) being applied to one end of the fourth switch driver circuit, after delaying, based on the second delay value output by the second delay, the fourth switch driver circuit may output a fourth enable signal to the fourth switch connected to the other end of the fourth switch driver circuit.

According to an embodiment, based on the second voltage being applied to one end of the second switch driver circuit, after delaying, based on a first delay value output by the first delay, the second switch driver circuit may output a second enable signal to the second switch connected to another end of the second switch driver circuit.

According to an embodiment, based on the first voltage being applied to one end of the third switch driver circuit, after delaying, based on the first delay value output by the first delay, the third switch driver circuit may output a third enable signal to the third switch connected to the other end of the third switch driver circuit.

According to an embodiment, after delaying a first period of time, based on the second delay value output by the second delay, the control circuit may control the first switch and the fourth switch to be turned on and the second switch and the third switch to be turned off during a second period, based on the first enable signal output from the first switch driver circuit and the fourth enable signal output from the fourth switch driver circuit.

According to an embodiment, after delaying for a third period of time, based on the first delay value output by the first delay, the control circuit may control the second switch and the third switch to be turned on and the first switch and the fourth switch to be turned off during a fourth period, based on the second enable signal being output from the second switch driver circuit and the third enable signal output from the third switch driver circuit.

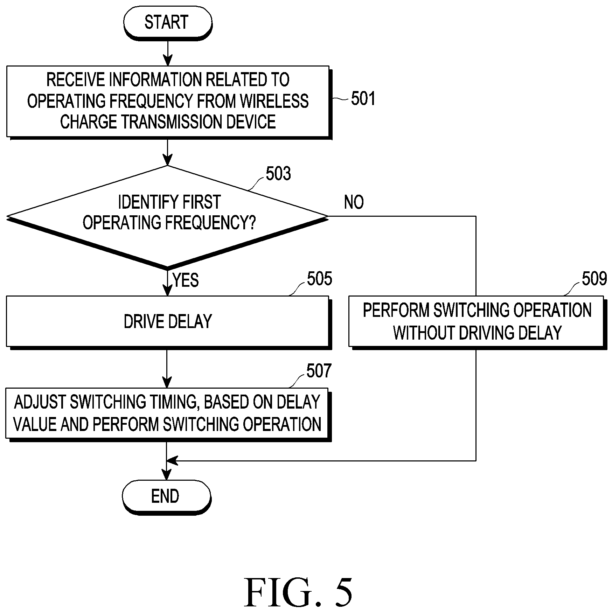

FIG. 5 is a diagram illustrating an example of an operation method in an electronic device according to an embodiment. In the following embodiments, each operation may be performed sequentially, but is not necessarily performed sequentially. For example, the order of the operations may be changed, and at least two operations may be performed in parallel. In the description of the operation method according to an embodiment, a device for transmitting wireless power (e.g., a wireless power transmitting device) may be referred to as an external electronic device, and a device for receiving wireless power (e.g., a wireless power receiving device) may be referred to as an electronic device.

An electronic device (e.g., the electronic device 101 of FIG. 1, the electronic device 101 of FIGS. 2A, 2B, and 3) according to an embodiment may be a device that supports multiple operating frequencies.

Referring to FIG. 5, in operation 501, the electronic device may be connected to an external electronic device (e.g., the external electronic device 201 of FIGS. 2A, 2B, and 3) through a communication circuit 190 of the electronic device, and receive information related to an operating frequency (e.g., switching frequency) from the external electronic device through the communication circuit 190. That is, in operation 501 the electronic device 101 may receive or otherwise obtain information related to an operating frequency.

In operation 503, the electronic device may identify whether a first operating frequency is identified, based on the information related to the received operating frequency. As a result of identification, when the first operating frequency is identified, the electronic device may perform operation 505, otherwise, the electronic device may perform operation 509.

In operation 505 (operation 503 - Yes), the electronic device may drive (e.g. control, execute, operate, apply etc.) at least one delay (e.g., the first delay 333 and/or the second delay 343 in FIG. 3) included in a rectifier circuit (e.g., the rectifier circuit 255 in FIGS. 2B and 3) of the electronic device, based on the first operating frequency in the external electronic device or based on identifying the first operating frequency. For example, the rectifier circuit may be connected in parallel to a resonance circuit of the electronic device, and include a plurality of switches (e.g., S1, S2, S3, and S4 in FIG. 3) and a plurality of switch driver circuits (e.g., a plurality of switch driver circuits 310, 320, 330, and 340 in FIG. 3) electrically connected to the plurality of switches, respectively. For example, at least one delay may be electrically connected to (e.g., included in) at least two switch driver circuits of the plurality of switch driver circuits.

In operation 507, the electronic device may adjust (e.g. modify, change, set, control etc.) the switching timing of at least two switches each connected to at least two switch driver circuits among the plurality of switches with a specified delay value, and perform a switching operation of a plurality of switches, based on the adjusted switching timing. For example, the delay value of the first delay 333 and/or the second delay 343 is adjusted to adjust the switching timing of the first switch S1 and the fourth switch S4 and/or the second switch S2 and the third switch S3, respectively.

In operation 509 (operation 503-No), the electronic device may identify a second operating frequency (e.g., 145 kHz), based on the first operating frequency not being identified in the external electronic device or based on identifying the second operating frequency itself, and perform switching operations of the plurality of switches without time delay without operating the delay, based on the second operating frequency. The second operating frequency may be a lower operating frequency than the first operating frequency, e.g. the first operating frequency is 350kHz.

According to an embodiment, when performing the operation of performing switching of the plurality of switches in operation 507, the electronic device may delay a certain period of time, based on a delay value output by a second delay (e.g., the second delay 343 in FIG. 3) included in the fourth switch driver circuit, based on the first voltage being applied to the first switch driver circuit (e.g., the first switch driver circuit 310 in FIG. 3) among the plurality of switch drivers and the second voltage being applied to the fourth switch driver circuit (e.g., the fourth switch driver circuit 340 in FIG. 3). After delaying for the certain period of time, the electronic device may output an enable signal to the first switch among the plurality of switches by the first switch driver circuit, and output an enable signal to the fourth switch by the fourth switch driver circuit. After delaying for another certain period of time (which may be the same as or different to the previously mentioned certain period of time), based on the delay value output by the second delay, the electronic device may turn on the first switch and the fourth switch and turn off the second switch and the third switch during a first period, based on the enable signal being output from each of the first switch driver circuit and the fourth switch driver circuit.

According to an embodiment, when performing the operation of performing switching of the plurality of switches in operation 507, the electronic device may delay a certain period of time, based on a delay value output by the first delay (e.g., the first delay 333 in FIG. 3) included in the third switch driver circuit, based on the second voltage being applied to one end of the second switch driver circuit (e.g., the second switch driver circuit 320 in FIG. 3) among the plurality of switch drivers and the first voltage being applied to one end of the third switch driver (e.g., the third switch driver circuit 330 in FIG. 3). After delaying for the certain time period, the electronic device may output an enable signal to the second switch among the plurality of switches by the second switch driver circuit and output an enable signal to the third switch by the third switch driver circuit. After delaying for another certain period of time (which may be the same as or different to the previously mentioned certain period of time), based on the delay value output by the first delay, the electronic device may turn on the second switch and the third switch and turn off the first switch and the fourth switch during a second period, based on the enable signal being output from the second switch driver circuit and the third switch driver circuit.

According to an embodiment, an operation method in an electronic device (e.g., the electronic device 101 of FIG. 1 and the external electronic device 201 of FIGS. 2A, 2B, and 3) may include identifying a first operating frequency received from an external electronic device (201), based on the information related to the operating frequency received from an external electronic device (201).

According to an embodiment, the method may include driving at least one delay included in a rectifier circuit (e.g., the rectifier circuit 225 of FIG. 2B) of the electronic device, based on the first operating frequency.

According to an embodiment, the method may include adjusting the switching timing of at least two switches (S1, S2, S3, S4) each connected to the at least two switch driver circuits among the plurality of switches included in the rectifier circuit with the delay value of the at least one delay.

According to an embodiment, the method may include performing switching of the plurality of switches, based on the adjusted switching timing.

According to an embodiment, the plurality of switches may be each electrically connected to one of a plurality of switch driver circuits (e.g., a plurality of switch driver circuits 310, 320, 330, and 340 of FIG. 3) included in the rectifier circuit. According to an embodiment, at least two switch driver circuits among the plurality of switch driver circuits may be include the at least one delay.

According to an embodiment, the method may further include identifying a second operating frequency, based on the information related to the operating frequency, and performing switching of the plurality of switches without driving the at least one delay.

According to an embodiment, the performing of the switching of the plurality of switches may include turning on the at least two switches each connected to the at least two switch driver circuits with the adjusted switching timing and turning off the remaining switches.

According to an embodiment, the performing of the switching of the plurality of switches may include, based on a first voltage (Vac, p) being applied to one end of a first switch driver circuit among the plurality of switch drivers circuits, after delaying, based on a second delay value output by a second delay, outputting a first enable signal to a first switch, among the plurality of switches, connected to another end of the first switch driver circuit and based on a second voltage being (Vac, n) applied to one end of a fourth switch driver circuit among the plurality of switch driver circuits, after delaying, based on the second delay value output by the second delay, and outputting a fourth enable signal to the fourth switch, among the plurality of switches, connected to another end of the fourth switch driver circuit.

According to an embodiment, the second delay may be included in the fourth switch driver circuit.

According to an embodiment, the performing of the switching of the plurality of switches may include, based on the second voltage being applied to one end of a second switch driver circuit among the plurality of switch driver circuits, after delaying based on a delay value output by a first delay, outputting a second enable signal to the second switch, among the plurality of switches, connected to another end of the second switch driver circuit, and based on the first voltage being applied to one end of a third switch driver circuit among the plurality of switch driver circuits, after delaying based on the first delay value output by the first delay, outputting an enable signal to the third switch, among the plurality of switches, connected to another end of the third switch driver circuit.

According to an embodiment, the first delay may be included in the third switch driver circuit.

According to an embodiment, the performing of the switching of the plurality of switches may further include, after delaying for a first period of time, based on the second delay value output by the second delay, turning on the first switch and the fourth switch and turning off the second switch and the third switch during a second period, based on the first enable signal output from the first switch driver circuit and the fourth enable signal output from the fourth switch driver circuit.

According to an embodiment, the performing of the switching of the plurality of switches may further include, after delaying for a third period of time, based on the first delay value output by the first delay, turning on the second switch and the third switch and turning off the first switch and the fourth switch during a fourth period, based on the second enable signal output from the second switch driver circuit and the third enable signal output from the third switch driver circuit.

According to an embodiment, in a non-transitory storage medium for storing program, the program may include instructions, when executed by a processor of an electronic device (e.g., the electronic device 101 in FIG. 1 and the electronic device 101 in FIGS. 2A and 2B), configured to cause the electronic device to execute identifying a first operating frequency, based on the information related to the operating frequency received from an external electronic device (201), driving at least one delay included in a rectifier circuit (e.g., the rectifier circuit 225 of FIG. 2B) of the electronic device, based on the first operating frequency, adjusting switching timing of at least two switches connected to the at least two switch driver circuits among a plurality of switches included in the rectifier circuit with a delay value of the at least one delay, and performing switching of the plurality of switches, based on the adjusted switching timing.

According to an embodiment, the plurality of switches are each electrically connected to one of a plurality of switch driver circuits (e.g., the plurality of switch driver circuits 310, 320, 330, and 340 of FIG. 3) included in the rectifier circuit, and the at least two switch driver circuits among the plurality of switch driver circuits include the at least one delay.

According to an embodiment, an operation of performing switching of the plurality of switches may include turning on the at least two switches connected to the at least two switch driver circuits with the adjusted switching timing, and turning off remaining switches.

According to an embodiment, an electronic device (e.g., the electronic device 101 in FIG. 1 and the electronic device 101 in FIGS. 2A and 2B) can efficiently wirelessly charge when an operating frequency changes by using the switching operation of a rectifier circuit without configuring an additional circuit to change the resonance capacitor in a resonance circuit. The electronic device according to an embodiment can achieve the same effect as reducing the resonance capacitance due to the phase difference between the current and the input end (AC end) voltage through the switching operation in the rectifier circuit, and as a result, the electronic device can increase efficiency when the operating frequency changes.

Various other effects understood directly or indirectly through the present document may be provided. Advantageous effects obtainable from the disclosure may not be limited to the above-mentioned effects, and other effects which are not mentioned may be clearly understood, through the following descriptions, by those skilled in the art to which the disclosure pertains.

Furthermore, the embodiments disclosed herein have been presented to explain the technical contents of the disclosure and help the understanding thereof, and are not intended to limit the scope of the technology disclosed herein. Therefore, the scope of the disclosure should be construed to cover all changes and modifications or various other embodiments based on the technical idea of the disclosure.

The electronic device according to various embodiments may be one of various types of electronic devices. The electronic devices may include, for example, a portable communication device(e.g., a smart phone), a computer device, a portable multimedia device, a portable medical device, a camera, a wearable device, or a home appliance. The electronic device according to embodiments of the disclosure is not limited to those described above.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a resonance circuit including a coil (221) configured to wirelessly receive power from an external electronic device (201), and a first capacitor (222),
a rectifier circuit (255) connected to the resonance circuit;
a communication circuit (190); and
a control circuit (120, 250) electrically connected to the rectifier circuit, the resonance circuit, and the communication circuit,
wherein the rectifier circuit comprises:
a plurality of switches (S1, S2, S3, S4);
a plurality of switch driver circuits (310, 320, 330, 340) each electrically connected to one of the plurality of switches, wherein at least two switch driver circuits of the plurality of switch driver circuits include at least one delay,
wherein the control circuit is configured to:
based on information related to an operating frequency received from the external electronic device, identify a first operating frequency,
based on the first operating frequency, control to drive the at least one delay, adjust switching timing of at least two switches among the plurality of switches with a delay value of the at least one delay, and
based on the adjusted switching timing, control switching of the plurality of switches.

2. The electronic device of claim 1, wherein the control circuit is configured to:
based on the information related to the operating frequency, identify a second operating frequency, and
based on the second operating frequency, control switching operations of the plurality of switches without driving the at least one delay.

3. The electronic device of claim 1 or claim 2, wherein the control circuit is configured to control the rectifier circuit to turn on the at least two switches connected to the at least two switch driver circuits, respectively, with the adjusted switching timing.

4. The electronic device of any one of claims 1 to 3, further comprising a regulator connected to an output terminal of at least two switches among the plurality of switches, wherein the resonance circuit further includes a second capacitor (223),
wherein one end of the first capacitor is connected to the coil, and another end of the first capacitor is connected to the second capacitor, and
wherein one end of the second capacitor is connected in series to the other end of the first capacitor, another end of the second capacitor is connected to the coil, and the second capacitor is connected in parallel to the rectifier circuit.

5. The electronic device of any one of claims 1 to 4,
wherein the plurality of switch driver circuits includes a first switch driver circuit (310), a second switch driver circuit (320), a third switch driver circuit (330), and a fourth switch driver circuit (340),
wherein the plurality of switches includes a first switch (S1), a second switch (S2), a third switch (S3), and a fourth switch (S4), and are configured as a full bridge circuit,
wherein the first switch driver circuit includes a first switch driver (311),
wherein the second switch driver circuit includes a second switch driver (321),
wherein the third switch driver circuit includes a third switch driver (331), a first comparator (335), and a first delay (333),
wherein the first delay is disposed between the second switch driver and the first comparator,
wherein the fourth switch driver circuit includes a fourth switch driver (341), a second comparator (345), and a second delay (343),
wherein the second delay is disposed between the fourth switch driver and the second comparator.

6. The electronic device of claim 5,
wherein the first switch driver circuit is configured to, based on a first voltage (Vac, p) being applied to one end of the first switch driver circuit, after delaying based on a second delay value output by the second delay, output a first enable signal to the first switch connected to another end of the first switch driver circuit,
wherein the fourth switch driver circuit is configured to, based on a second voltage (Vac, n) being applied to one end of the fourth switch driver circuit, after delaying based on the second delay value output by the second delay, output a fourth enable signal to the fourth switch connected to another end of the fourth switch driver circuit, wherein the second switch driver circuit is configured to, based on the second voltage being applied to one end of the second switch driver circuit, after delaying based on a first delay value output by the first delay, output a second enable signal to the second switch connected to another end of the second switch driver circuit, and
wherein the third switch driver circuit is configured to, based on the first voltage being applied to one end of the third switch driver circuit, after delaying based on the first delay value output by the first delay, output a third enable signal to the third switch connected to another end of the third switch driver circuit.

7. The electronic device of claim 6, wherein the control circuit is configured to:
after delaying for a first period of time based on the second delay value output by the second delay, based on the first enable signal output from the first switch driver circuit and the fourth enable signal output from the fourth switch driver circuit, control the first switch and the fourth switch to turn on and the second switch and the third switch to turn off during a second period, and after delaying for a third period of time based on the first delay value output by the first delay, based on the second enable signal output from the second switch driver circuit and the third enable signal output from the third switch driver circuit, control the second switch and the third switch to turn on and the first switch and the fourth switch to turn off during a fourth period.

8. An operation method of operating an electronic device (101), the method comprising:
based on information related to the operating frequency received from an external electronic device (201), identifying a first operating frequency;
based on the first operating frequency, driving at least one delay included in a rectifier circuit (255) of the electronic device;
adjusting switching timing of at least two switches among a plurality of switches (S1, S2, S3, S4) included in the rectifier circuit with a delay value of the at least one delay; and
based on the adjusted switching timing, performing switching of the plurality of switches;
wherein the plurality of switches are each electrically connected to one of a plurality of switch driver circuits (310, 320, 330, 340) included in the rectifier circuit; and
wherein at least two switch driver circuits of the plurality of switch driver circuits include the at least one delay.

9. The method of claim 8, further comprising:
based on the information related to the operating frequency, identifying a second operating frequency; and
based on the second operating frequency, performing switching of the plurality of switches without driving the at least one delay.

10. The method of claim 8 or claim 9, wherein the performing of the switching of the plurality of switches comprises turning on the at least two switches respectively connected to the at least two switch driver circuits with the adjusted switching timing, and turning off remaining switches.

11. The method of one of claims 8 to 10, wherein the performing of the switching of the plurality of switches comprises:
based on a first voltage (Vac, p) being applied to one end of a first switch driver circuit among the plurality of switch driver circuits, after delaying based on a second delay value output by a second delay (343), outputting a first enable signal to a first switch, among the plurality of switches, connected to another end of the first switch driver circuit;
based on a second voltage (Vac, n) being applied to one end of a fourth switch driver circuit among the plurality of switch driver circuits, after delaying based on the second delay value output by the second delay, outputting a fourth enable signal to the fourth switch, among the plurality of switches, connected to another end of the fourth switch driver circuit,
based on the second voltage being applied to one end of a second switch driver circuit among the plurality of switch driver circuits, after delaying based on a delay value output by a first delay (333), outputting a second enable signal to the second switch, among the plurality of switches, connected to another end of the second switch driver circuit; and
based on the first voltage being applied to one end of a third switch driver circuit among the plurality of switch driver circuits, after delaying based on the first delay value output by the first delay, outputting an enable signal to the third switch, among the plurality of switches, connected to another end of the third switch driver circuit;
wherein the first delay is included in the third switch driver circuit; and
wherein the second delay is included in the fourth switch driver circuit.

12. The method of claim 11, wherein the performing of the switching of the plurality of switches further comprises:
after delaying for a first period of time, based on the second delay value output by the second delay, turning on the first switch and the fourth switch and turning off the second switch and the third switch during a second period, based on the first enable signal output from the first switch driver circuit and the fourth enable signal output from the fourth switch driver circuit; and after delaying for a third period of time, based on the first delay value output by the first delay, turning on the second switch and the third switch and turning off the first switch and the fourth switch during a fourth period, based on the second enable signal output from the second switch driver circuit and the third enable signal output from the third switch driver circuit.

13. A non-transitory storage medium for storing program,
wherein the program includes instructions configured to, when executed by a processor of an electronic device (101), cause the electronic device to execute:
, based on information related to the operating frequency received from an external electronic device (201), identifying a first operating frequency;
based on the first operating frequency, driving at least one delay included in a rectifier circuit (255) of the electronic device;
adjusting switching timing of at least two switches among a plurality of switches (S1, S2, S3, S4) included in the rectifier circuit with a delay value of the at least one delay; and
based on the adjusted switching timing, performing switching of the plurality of switches,
wherein the plurality of switches are each electrically connected to one of a plurality of switch driver circuits (310, 320, 330, 340) included in the rectifier circuit, and
wherein at least two switch driver circuits among the plurality of switch driver circuits include the at least one delay.

14. The non-transitory storage medium of claim 13, wherein the performing of the switching of the plurality of switches includes turning on the at least two switches respectively connected to the at least two switch driver circuits with the adjusted switching timing, and turning off remaining switches.

15. The non-transitory storage medium of claim 13 or claim 14, the performing of the switching of the plurality of switches comprises:
based on a first voltage (Vac, p) being applied to one end of a first switch driver circuit among the plurality of switch driver circuits, after delaying based on a second delay value output by a second delay (343), outputting a first enable signal to a first switch, among the plurality of switches, connected to another end of the first switch driver circuit;
based on a second voltage (Vac, n) being applied to one end of a fourth switch driver circuit among the plurality of switch driver circuits, after delaying based on the second delay value output by the second delay, outputting a fourth enable signal to the fourth switch, among the plurality of switches, connected to another end of the fourth switch driver circuit,
based on the second voltage being applied to one end of a second switch driver circuit among the plurality of switch driver circuits, after delaying based on a delay value output by a first delay (333), outputting a second enable signal to the second switch, among the plurality of switches, connected to another end of the second switch driver circuit; and
based on the first voltage being applied to one end of a third switch driver circuit among the plurality of switch driver circuits, after delaying based on the first delay value output by the first delay, outputting an enable signal to the third switch, among the plurality of switches, connected to another end of the third switch driver circuit;
wherein the first delay is included in the third switch driver circuit; and
wherein the second delay is included in the fourth switch driver circuit.
